# EUROPEAN PATENT SPECIFICATION

(11) **EP 3 842 812 B1**
(45) Date of publication and mention of the grant of the patent: **25.01.2023**
(21) Application number: 19219721.8
(22) Date of filing: 26.12.2019
(51) Int. Cl.: G01R 15/18

(54) **MEASURING APPARATUS FOR MEASURING A DC COMPONENT OF AN ELECTRIC CURRENT AND ASSOCIATED MEASURING METHOD**
MESSVORRICHTUNG ZUR MESSUNG EINER GLEICHSTROMKOMPONENTE EINES ELEKTRISCHEN STROMS UND ZUGEHÖRIGES MESSVERFAHREN
APPAREIL DE MESURE D'UN COMPOSANT À COURANT CONTINU D'UN COURANT ÉLECTRIQUE ET PROCÉDÉ DE MESURE ASSOCIÉ

(43) Date of publication of application: 30.06.2021
(73) Proprietor: General Electric Technology GmbH, 5400 Baden (CH)
(72) Inventor: STURGESS, Jonathan Peter, Staffordshire, Staffordshire ST17 4UQ (GB)
(74) Representative: Brevalex

(56) References cited:
- EP-A1- 2 952 997
- WO-A2-2008/030129
- KR-A- 20110 017 774

## Description

### TECHNICAL FIELD

The invention concerns a measuring apparatus for measuring a DC component of at least one electric current, each electric current being output from a corresponding source. The invention also concerns a method for measuring said DC component.

The invention applies to the field of electric power transmission, and more particularly to the monitoring of transformers.

### BACKGROUND ART

It is known that the presence of an offset, that is to say a DC component, in an electric current applied to a transformer may cause a time-independent magnetic flux (hereafter called "DC flux") to appear in the magnetic core of said transformer, which may cause an increase of the transformer audible noise and/or heating of the transformer.

Such an offset may be caused by electronic devices arranged upstream from the transformer, such as HVDC (High Voltage, Direct Current) valves and static VAR (Volt-Ampere Reactive) compensators.

Moreover, a DC flux in a transformer can also be geomagnetically-induced.

To reduce such a DC flux, it is known to measure the DC component of the electric current applied to the transformer and, based on this measurement, to control the aforementioned electronic devices to cancel said DC component.

As an alternative, it is also known to measure said DC component, and to control the amplitude and direction of a direct current injected into separate winding(s) in the transformer, in order to oppose and cancel the DC flux in the magnetic core of the said transformer.

However, such methods are not satisfactory.

Indeed, there is a detection threshold (around 2A) below which the DC component of a large, noisy input electric current cannot be detected and measured simply and economically. Therefore, the residual DC current (that is to say the part of the DC component which is below the detection threshold) is not detected, and cannot be removed. Yet, this residual DC current is detrimental to a proper operation of the transformer. Prior art can be found in EP2952997 and WO2008/030129.

A purpose of the invention is to provide a measuring apparatus that is able to economically measure a DC component having a low magnitude in an electric current.

### SUMMARY OF THE INVENTION

To this end, the present invention is a measuring apparatus of the aforementioned type, comprising a computer and at least one current detector, each current detector being associated to a corresponding source and including:
- a first conductor extending between a first terminal and a second terminal for connection to the source;
- a tube-shaped screen made in an electrically conductive material and defining an inner volume, the screen being configured to provide a closed electrical path for eddy current flow to generate a compensation magnetic field for compensating a time-dependent component of a response magnetic field generated by a flow, in the first conductor, of the corresponding electric current; and
- a magnetic sensor arranged in the inner volume of the screen, the magnetic sensor being configured to detect a resulting magnetic field in the inner volume, and to output a detection signal representative of the detected resulting magnetic field,

the first conductor being arranged outside the inner volume of the screen,
the computer being connected to the magnetic sensor of each current detector to receive the corresponding detection signal,
the computer further being configured to determine, for each source, the DC component of the corresponding electric current based on the detection signal output from the magnetic sensor of the associated current detector.

Indeed, in such a measuring apparatus, the first conductor generates the response magnetic field when the electric current output from the source flows through said first conductor.

If the electric current has both DC and AC components, then the response magnetic field also comprises a time-independent component and a time-dependent component which are directly related to said DC and AC components, respectively.

The time-dependent component of the response magnetic field causes eddy currents to flow in the screen, which, in turn, generates the compensation magnetic field. These eddy currents act to cancel the applied time-dependent component of the response magnetic field, whereas its time-independent component passes through the screen. Therefore, the resulting magnetic field in the inner volume corresponds to the time-independent component alone of the response magnetic field.

Since the magnitude of the response magnetic field is in direct proportion to the DC component of the current output from the source, the detection signal is representative of said DC component and a measurement of the DC component is therefore easily be achieved.

It results from the foregoing that, through the use of the measuring apparatus according to the invention, a signal wherein the influence of the AC component has been removed is generated by the magnetic sensor. This allows for a simple and efficient measurement of the DC component of the electric current output from the source, even for small DC component magnitudes, and despite the presence of a large and noisy AC component.

According to other advantageous aspects of the invention, the measuring apparatus includes one or more of the following features, taken alone or in any possible combination:
- the computer is further configured to output, based on each determined DC component, a control signal to control the corresponding source for reduction or cancellation of the corresponding DC component;
- each current detector further comprises a magnetic core having a first section arranged in the inner volume of the screen;
- the first section of the magnetic core comprises a gap, the magnetic sensor being arranged in the gap;
- for each current detector, the corresponding first conductor is a coil wound around a second section of the magnetic core;
- the first section and the second section are the same, the first conductor and the screen being concentric;
- for each current detector, the magnetic core is hoop-shaped, the screen extending along a toroidal direction of the magnetic core, the first conductor extending through a central opening of the hoop-shaped magnetic core, or being wound around the screen;
- for each current detector, the screen comprises a first end and a second end, the first end and the second end adjoining one another, and being in electrical contact with one another;
- the screen is a short-circuited coil;
- the measuring apparatus comprises at least two current detectors, the computer being configured to compare, to each other, the detection signals output from each magnetic sensor, and to determine that:
   - the DC component in the electric current output from each source flows up a common neutral connection of the sources, if the detected resulting magnetic fields have a same orientation; and
   - the DC component in the electric current output from each source arises from at least one source, if the detected resulting magnetic fields do not have the same orientation, and have a sum equal to zero or below a predetermined value.

The invention also relates to a measuring method for measuring a DC component of at least one electric current, each electric current being output from a corresponding source, the measuring method comprising:
- receiving a detection signal from at least one current detector, each current detector being associated to a corresponding source and including:
   - a first conductor extending between a first terminal and a second terminal, the first terminal and the second terminal being connected to the source;
   - a tube-shaped screen made in an electrically conductive material and defining an inner volume, the screen being configured to provide a closed electrical path for eddy current flow to generate a compensation magnetic field for compensating a time-dependent component of a response magnetic field generated by a flow, in the first conductor, of the corresponding electric current; and
   - a magnetic sensor arranged in the inner volume of the screen, the magnetic sensor being configured to detect a resulting magnetic field in the inner volume, and to output the detection signal, the detection signal being representative of the detected resulting magnetic field,
   the first conductor being arranged outside the inner volume of the screen,
- determining, for each source, the DC component of the corresponding electric current based on the detection signal output from the magnetic sensor of the associated current detector.

According to another advantageous aspects of the invention, the measuring method includes the following feature: each of at least two current detectors is connected to a corresponding source, the measuring method further comprising;
- comparing, to each other, the detection signals output from each magnetic sensor; and
- determining that:
   - the DC component in the electric current output from each source flows up a common neutral connection of the sources, if the detected resulting magnetic fields have a same orientation; and
   - the DC component in the electric current output from each source arises from at least one source, if the detected resulting magnetic fields do not have the same orientation, and have a sum equal to zero or below a predetermined value.

### BRIEF DESCRIPTION OF THE DRAWINGS

The invention will be better understood with the attached figures, in which:
- figure 1 is schematic view of a first measuring apparatus according to the invention;
- figure 2 is a graph showing the evolution over time of an electric current flowing through a first conductor of the measuring apparatus of figure 1, and of eddy currents generated by a corresponding screen of the measuring apparatus;
- figure 3 is a graph showing the evolution over time of a magnetic flux in an inner volume of the screen of the measuring apparatus of figure 1;
- figure 4 is a schematic view of a magnetic core of a second measuring apparatus according to the invention, with magnetic fields in the magnetic coupler arising from geomagnetically-induced DC currents;
- figure 5 is similar to figure 4, the magnetic fields in the magnetic coupler arising from offsets in each source feeding the measuring apparatus; and
- figure 6 is a perspective view of a current detector of a third measuring apparatus according to the invention.

### DESCRIPTION OF PREFERED EMBODIMENTS

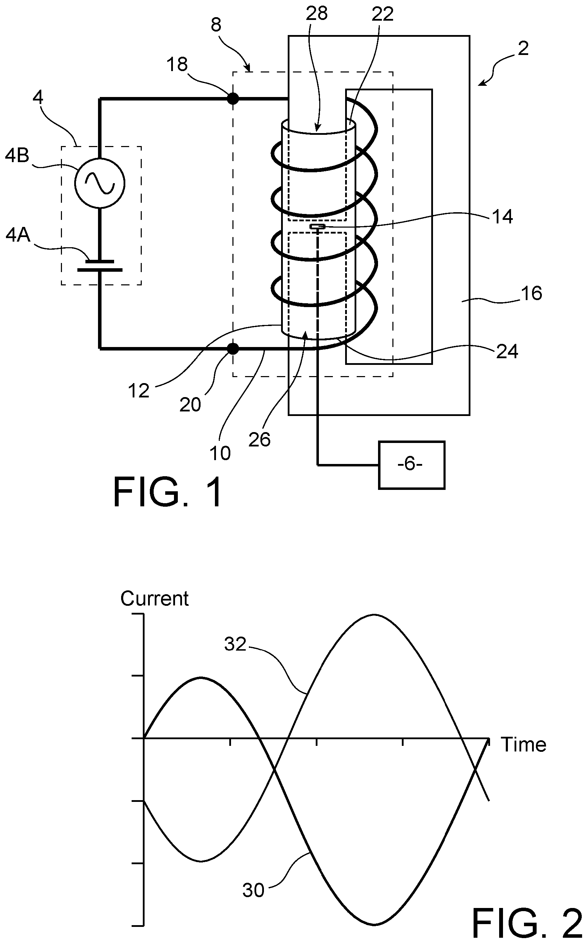

A measuring apparatus 2 according to the invention is shown on figure 1. The measuring apparatus 2 is configured to measure a DC component of at least one electric current, each electric current being output from a corresponding source 4.

The electric current generally comprises a time-independent component (hereafter called "DC current") and a time dependent component (hereafter called "AC current"). The DC current corresponds to the current to be measured and cancelled, and has, for instance, a magnitude of a few milliamps.

In general, the AC current is several orders of magnitude greater that the DC component, and has, for instance, a magnitude between several tens of amps and a few thousands of amps.

The source 4 is schematically shown, in figure 1, as a series connection of a DC source 4A, which provides the DC current, and an AC source 4B, which outputs the AC current.

The measuring apparatus 2 comprises a computer 6 and, for each source 4, a corresponding current detector 8. For example, as will be shown below, for three-phase applications, the measuring apparatus 2 comprises three current detectors 8, each corresponding to a respective phase.

The current detector 8 is configured to output a detection signal representative of the DC component of the electric current output from the source 4. Moreover, the computer 6 is configured to determine the DC component of said electric current based on the detection signal.

The current detector 8 comprises a first conductor 10, a screen 12 and a magnetic sensor 14. Preferably, the current detector 8 also includes a magnetic core 16.

The first conductor 10 extends between a first terminal 18 and a second terminal 20 for connection to the corresponding source 4.

More specifically, the first conductor 10 is configured to generate a response magnetic field when the electric current output from the source 4 flows between the first terminal 18 and the second terminal 20 through said first conductor 10.

Such a response magnetic field comprises a time-independent component and a time-dependent component: the time-independent component depends on the DC current from the DC source 4A, whereas the time-dependent component depends on the AC current from the AC source 4B.

For instance, the first conductor 10 is a coil, such as a secondary winding of a transformer.

The first conductor 10 is arranged, with respect to the screen 12, so as to be outside an inner volume 26 of the screen 12.

The screen 12 has a tube-like shape and extends between a first end 22 and a second end 24. The screen 12 defines, between the first end 22 and the second end 24, the aforementioned inner volume 26.

The screen 12 is made in an electrically conductive material and is configured to provide a closed electrical path for eddy current flow so as to generate a compensation magnetic field for compensating the time-dependent component of the response magnetic field.

For instance, the screen 12 is a short-circuited coil, such as a short-circuited primary winding of a transformer. Alternatively, the screen 12 is a cylinder made in an electrically conductive material.

As shown on figure 1, the first conductor 10 and the screen 12 are preferably concentric, the first conductor 10 being wound around the screen 12.

The magnetic sensor 14 is arranged in the inner volume 26 and is configured to detect a resulting magnetic field in said inner volume 26. The resulting magnetic field corresponds to the spatial superposition of the response magnetic field and the compensation magnetic field.

The magnetic sensor 14 is also configured to output a detection signal representative of the detected resulting magnetic field.

For instance, the magnetic sensor 14 is a Hall-effect sensor.

As stated above, the current detector 8 preferably comprises a magnetic core 16, a first section 28 of the magnetic core 16 being arranged in the inner volume 26 of the screen 12.

The presence of the magnetic core 16 increases the strength of magnetic fields in the inner volume 26 with respect to their strength without the magnetic core 16. As a result, the signal-to-noise ratio of the detection signal output from the magnetic sensor 14 is enhanced, and the necessity to shield the current detector 8 from external magnetic fields is reduced.

Advantageously, the magnetic core 16 comprises at least one gap 30. Preferably, the gap 30 is located in the inner volume 26 of the screen 12; in other words, the first section 28 of the magnetic core 16 comprises the gap 30. In this case, the magnetic sensor 14 is preferably arranged in the gap 30.

The presence of the gap 30 reduces magnetic saturation of the magnetic core 16, and therefore prevents undesirable non-linear relationships between, for instance, the electric current and the response magnetic field.

For instance, the first conductor 10 is wound around a second section of the magnetic core 16. Preferably, the first section 28 and the second section are the same, so that the first conductor 10 and the screen 12 are concentric.

Alternatively, the second section is distinct from the first section 28.

The computer 6 is connected to the magnetic sensor 14 of each current detector 8 to receive the corresponding detection signal.

The computer 6 is further configured to determine, for each source 4, the DC component of the corresponding electric current, based on the detection signal output from the magnetic sensor 14 of the associated current detector 8. Such a determination is, for instance, based on a calibration that is performed with known electrical currents applied to the first conductor 10.

Advantageously, the computer 6 is further configured to output, for each source 4, a control signal based on the corresponding determined DC component. Said control signal is preferably meant for control of the source 4 in order to reduce or even cancel the corresponding DC component. For instance, said control signal is meant for control of electronic devices of the source 4. Alternatively, when the source 4 feeds electric power to a transformer, said control signal is, for instance, meant for control of an amplitude and a direction of a direct current injected into separate winding(s) in the transformer, in order to oppose and cancel a DC flux in a magnetic core of said transformer that is caused by the DC component of the electric current output from the source. Such separate windings are distinct from a primary and a secondary winding of the transformer.

Advantageously, if the measuring apparatus 2 comprises multiple current detectors 8, the computer 6 is further configured to compare the detection signals output from each current detector 8 in order to determine information regarding each source 4. An example relating to a three-phase source will be provided below.

The operation of the measuring apparatus 2 will now be disclosed.

The first conductor 10 of each current detector 8 is connected to the corresponding source 4, and electric current flows through the conductor 10.

The evolution over time of said electric current corresponds to curve 30 on figure 2.

Consequently, the first conductor 10 generates the response magnetic field, which comprises a time-independent component and a time-dependent component.

Due to the geometry of the screen 12, the time-dependent component of the response magnetic field causes eddy currents to flow in the screen 12; this, in turn, generates the compensation magnetic field. These eddy currents act to cancel the applied time-dependent component of the response magnetic field. Hence, as shown on figure 2, the eddy currents (curve 32) are equal to the opposite of the AC component of the electric current 30, while their average over time is equal to zero.

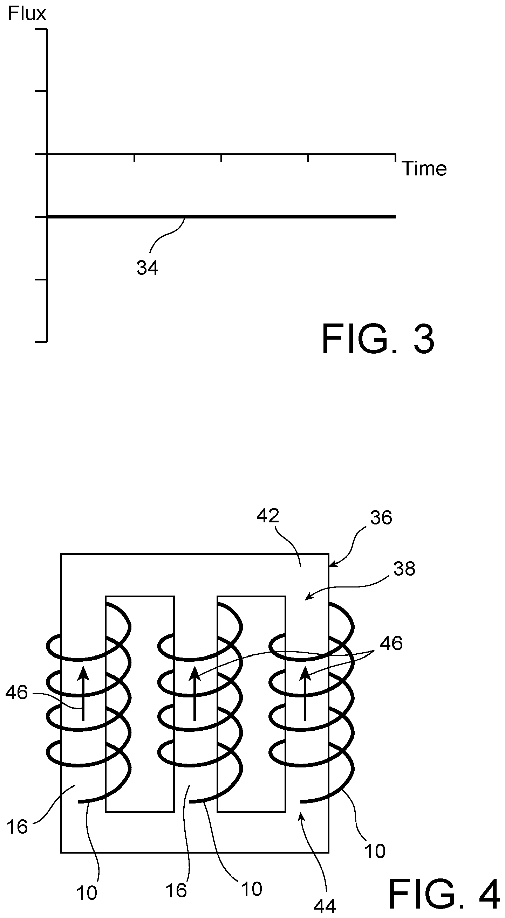

On the other hand, the time-independent component of the response magnetic field passes through the screen 12, forming the resulting magnetic field, the latter also being time-independent. This corresponds to the constant curve 34 on figure 3.

The magnetic sensor 14 detects the resulting magnetic field and outputs the corresponding detection signal.

The computer 6 receives the detection signal output from each magnetic sensor 14 and determines, for each source 4, the DC component of the corresponding electric current, based on the corresponding detection signal.

Advantageously, the computer 6 outputs, for each source 4, a control signal meant for control of the source 4 in order to reduce or even cancel the corresponding DC component.

Alternatively, the current detector 8 further comprises additional screens (not shown) that are similar to screen 12, in order to increase AC shielding efficiency. In this case, each additional screen corresponds to a section of the magnetic core 16 that is distinct from the first section 28, said section of the magnetic core 16 being arranged in the inner volume of the corresponding additional screen.

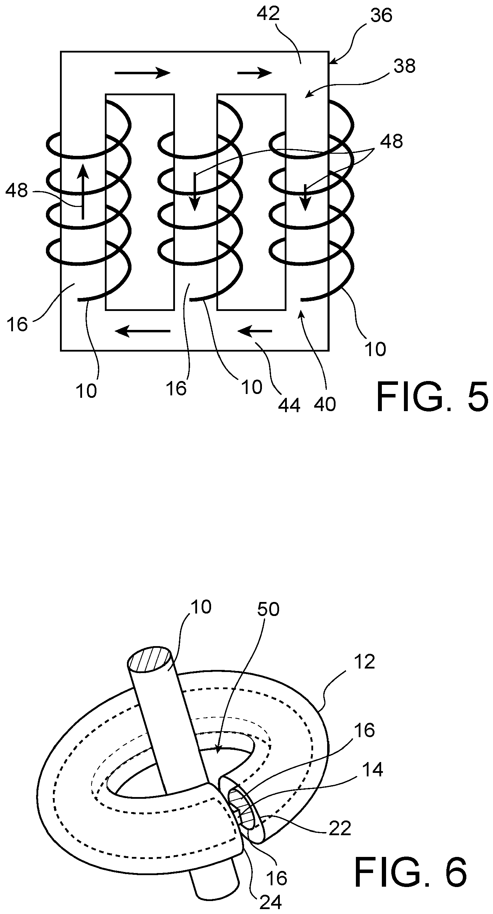

Figures 4 and 5 correspond to a measuring apparatus used in three-phase applications. For instance, each first conductor 10 is connected to a corresponding phase of a three-phase source (not shown).

As shown on these figures, each magnetic core 16 forms a limb which extends between a first limb end 38 and a second limb end 40, a first yoke 42 connecting the first limb ends 38, and a second yoke 44 connecting the second limb ends 40. Thus a magnetic coupler 36 is formed.

Moreover, each first conductor 10 is wound around a corresponding magnetic core 16. For clarity purposes, only the first connectors 10 and the magnetic cores 16 have been shown; however, each magnetic core 16 of is provided with a corresponding screen and magnetic sensor.

In this case, the computer 6 is configured to compare the detection signals output from each magnetic sensor.

If the three detected resulting magnetic fields have the same orientation (as shown in figure 4 by arrows 46), the computer 6 is configured to determine that the DC component in each phase flows up the neutral connection into all phases (e.g. geomagnetically induced currents).

If, as shown in figure 5 by arrows 48, the three detected resulting magnetic fields do not have the same orientation, and the sum of their values is zero or close to zero (that is to say lower than a predetermined value), the computer 6 is configured to determine that the DC component in each phase is due to the supply voltage waveforms (i.e. due to the three-phase source itself).

It is understood that similar operation is envisaged for any number of sources greater than or equal to 2.

In another embodiment of the measuring apparatus according to the invention, shown in figure 6, the screen 12 has adjoining first and second ends 22, 24, the first and second ends facing one another and being in electrical contact with one another, so that the screen 12 defines a toroid. In this figure, part of the screen 16 has been removed for clarity.

In this case, the screen 12 is preferably arranged around the entire length of a hoop-shaped magnetic core 16, for instance toroidally-shaped. In other words, the screen 12 extends along a toroidal direction of the magnetic core 16.

For instance, as shown in figure 6, the first conductor 10 extends through a central opening 50 of said toroid.

Alternatively, the screen 12 is only arranged around a corresponding first section of the magnetic core 16. Preferably, the first section comprises a gap, the magnetic sensor being located in said gap.

In this case, the current detector preferably comprises additional screens (not shown) that are similar to the screen 12, each additional screen being arranged around a corresponding section of the magnetic core 16 that is distinct from the first section 28.

Alternatively, the first conductor 10 is wound around the screen 12. Such an arrangement is advantageous, since it improves the immunity of the current detector to external field sources.

The measuring apparatus 2 according to the invention has several further advantages:
- it does not need not be placed inside a transformer tank, so that it can easily be retro-fitted to existing transformers;
- it can derive its excitation from a current or voltage transformer, so that it can be a low-voltage device: indeed, the current being monitored in the line connected to the transformer is generally operating at tens of thousands of volts to earth; using a current or voltage transformer as the source to be monitored by the measuring apparatus 2 allows the latter to operate at much lower voltage to earth;
- it is simple, robust and does not require an external power source;
- it uses inexpensive electronic components.

## Claims

1. A measuring apparatus (2) for measuring a DC component of at least one electric current, each electric current being output from a corresponding source (4), the measuring apparatus (2) comprising a computer (6) and at least one current detector (8), each current detector (8) being associated to a corresponding source (4) and including:
- a first conductor (10) extending between a first terminal (18) and a second terminal (20) for connection to the source (4);
- a tube-shaped screen (12) made in an electrically conductive material and defining an inner volume (26), the screen (12) being configured to provide a closed electrical path for eddy current flow to generate a compensation magnetic field for compensating a time-dependent component of a response magnetic field generated by a flow, in the first conductor (10), of the corresponding electric current; and
- a magnetic sensor (14) arranged in the inner volume (26) of the screen (12), the magnetic sensor (14) being configured to detect a resulting magnetic field in the inner volume (26), and to output a detection signal representative of the detected resulting magnetic field,
the first conductor (10) being arranged outside the inner volume (26) of the screen (12),
the computer (6) being connected to the magnetic sensor (14) of each current detector (8) to receive the corresponding detection signal,
the computer (6) further being configured to determine, for each source (4), the DC component of the corresponding electric current based on the detection signal output from the magnetic sensor (14) of the associated current detector (8).

2. The measuring apparatus according to claim 1, wherein the computer (6) is further configured to output, based on each determined DC component, a control signal to control the corresponding source for reduction or cancellation of the corresponding DC component.

3. The measuring apparatus according to claim 1 or 2, wherein each current detector (8) further comprises a magnetic core (16) having a first section arranged in the inner volume of the screen.

4. The measuring apparatus according to claim 3, wherein the first section of the magnetic core comprises a gap, the magnetic sensor being arranged in the gap.

5. The measuring apparatus according to claim 3 or 4, wherein, for each current detector, the corresponding first conductor is a coil wound around a second section of the magnetic core.

6. The measuring apparatus according to claim 5, wherein the first section and the second section are the same, the first conductor and the screen being concentric.

7. The measuring apparatus according to any one of claims 3 to 6, wherein, for each current detector, the magnetic core is hoop-shaped, the screen extending along a toroidal direction of the magnetic core, the first conductor extending through a central opening of the hoop-shaped magnetic core, or being wound around the screen.

8. The measuring apparatus according to claim 7, wherein, for each current detector, the screen comprises a first end and a second end, the first end and the second end adjoining one another, and being in electrical contact with one another.

9. The measuring apparatus according to any one of claims 1 to 8, wherein the screen is a short-circuited coil.

10. The measuring apparatus according to any one of claims 1 to 8, comprising at least two current detectors, the computer being configured to compare, to each other, the detection signals output from each magnetic sensor, and to determine that:
- the DC component in the electric current output from each source flows up a common neutral connection of the sources, if the detected resulting magnetic fields have a same orientation; and
- the DC component in the electric current output from each source arises from at least one source, if the detected resulting magnetic fields do not have the same orientation, and have a sum equal to zero or below a predetermined value.

11. A measuring method for measuring a DC component of at least one electric current, each electric current being output from a corresponding source (4), the measuring method comprising:
- receiving a detection signal from at least one current detector (8), each current detector (8) being associated to a corresponding source (4) and including:
• a first conductor (10) extending between a first terminal (18) and a second terminal (20), the first terminal (18) and the second terminal (20) being connected to the source (4);
• a tube-shaped screen (12) made in an electrically conductive material and defining an inner volume (26), the screen (12) being configured to provide a closed electrical path for eddy current flow to generate a compensation magnetic field for compensating a time-dependent component of a response magnetic field generated by a flow, in the first conductor (10), of the corresponding electric current; and
• a magnetic sensor (14) arranged in the inner volume (26) of the screen (12), the magnetic sensor (14) being configured to detect a resulting magnetic field in the inner volume (26), and to output the detection signal, the detection signal being representative of the detected resulting magnetic field,
the first conductor (10) being arranged outside the inner volume (26) of the screen (12),
- determining, for each source (4), the DC component of the corresponding electric current based on the detection signal output from the magnetic sensor (14) of the associated current detector (8).

12. The measuring method according to claim 11, wherein each of at least two current detectors is connected to a corresponding source, the measuring method further comprising;
- comparing, to each other, the detection signals output from each magnetic sensor; and
- determining that:
• the DC component in the electric current output from each source flows up a common neutral connection of the sources, if the detected resulting magnetic fields have a same orientation; and
• the DC component in the electric current output from each source arises from at least one source, if the detected resulting magnetic fields do not have the same orientation, and have a sum equal to zero or below a predetermined value.

## Patentansprüche

1. Messeinrichtung (2) zum Messen einer Gleichstromkomponente von mindestens einem elektrischen Strom, wobei jeder elektrische Strom von einer entsprechenden Quelle (4) ausgegeben wird, wobei die Messeinrichtung (2) einen Computer (6) und mindestens einen Stromdetektor (8) umfasst, wobei jeder Stromdetektor (8) einer entsprechenden Quelle (4) zugehörig ist und beinhaltet:
- einen ersten Leiter (10), der sich zur Verbindung mit der Quelle (4) zwischen einem ersten Anschluss (18) und einem zweiten Anschluss (20) erstreckt;
- eine röhrenförmige Abschirmung (12), hergestellt aus einem elektrisch leitfähigen Material und ein Innenvolumen (26) definierend, wobei die Abschirmung (12) konfiguriert ist, um einen geschlossenen elektrischen Pfad für Wirbelstromfluss bereitzustellen, um ein Kompensationsmagnetfeld zum Kompensieren einer zeitabhängigen Komponente eines Antwortmagnetfelds zu generieren, das durch einen Fluss des entsprechenden elektrischen Stroms in dem ersten Leiter (10) generiert wird; und
- einen Magnetsensor (14), angeordnet in dem Innenvolumen (26) der Abschirmung (12), wobei der Magnetsensor (14) konfiguriert ist, um ein resultierendes Magnetfeld in dem Innenvolumen (26) zu detektieren, und ein für das detektierte Magnetfeld repräsentatives Detektionssignal auszugeben,
wobei der erste Leiter (10) außerhalb des Innenvolumens (26) der Abschirmung (12) angeordnet ist,
wobei der Computer (6) mit dem Magnetsensor (14) von jedem Stromdetektor (8) verbunden ist, um das entsprechende Detektionssignal zu empfangen,
wobei der Computer (6) weiter konfiguriert ist, um für jede Quelle (4) die Gleichstromkomponente des entsprechenden elektrischen Stroms auf Grundlage des von dem Magnetsensor (14) des zugehörigen Stromdetektors (8) ausgegebenen Detektionssignals zu bestimmen.

2. Messeinrichtung nach Anspruch 1, wobei der Computer (6) weiter konfiguriert ist, um auf Grundlage jeder bestimmten Gleichstromkomponente ein Steuersignal auszugeben, um die entsprechende Quelle zur Verringerung oder Annullierung der entsprechenden Gleichstromkomponente zu steuern.

3. Messeinrichtung nach Anspruch 1 oder 2, wobei jeder Stromdetektor (8) weiter einen Magnetkern (16) mit einem in dem Innenvolumen der Abschirmung angeordneten ersten Abschnitt umfasst.

4. Messeinrichtung nach Anspruch 3, wobei der erste Abschnitt des Magnetkerns einen Spalt umfasst, wobei der Magnetsensor in dem Spalt angeordnet ist.

5. Messeinrichtung nach Anspruch 3 oder 4, wobei für jeden Stromdetektor der entsprechende erste Leiter eine um einen zweiten Abschnitt des Magnetkerns herum gewundene Spule ist.

6. Messeinrichtung nach Anspruch 5, wobei der erste Abschnitt und der zweite Abschnitt der gleiche sind, wobei der erste Leiter und die Abschirmung konzentrisch sind.

7. Messeinrichtung nach einem der Ansprüche 3 bis 6, wobei für jeden Stromdetektor der Magnetkern reifenförmig ist, die Abschirmung sich entlang einer toroidalen Richtung des Magnetkerns erstreckt, der erste Leiter sich durch eine zentrale Öffnung des reifenförmigen Magnetkerns erstreckt oder um die Abschirmung herum gewunden ist.

8. Messeinrichtung nach Anspruch 7, wobei für jeden Stromdetektor die Abschirmung ein erstes Ende und ein zweites Ende umfasst, wobei das erste Ende und das zweite Ende sich aneinander anschließen und in elektrischem Kontakt miteinander vorliegen.

9. Messeinrichtung nach einem der Ansprüche 1 bis 8, wobei die Abschirmung eine kurzgeschlossene Spule ist.

10. Messeinrichtung nach einem der Ansprüche 1 bis 8, umfassend mindestens zwei Stromdetektoren, wobei der Computer konfiguriert ist, um die von jedem Magnetsensor ausgegebenen Detektionssignale miteinander zu vergleichen, und um zu bestimmen, dass:
- die Gleichstromkomponente in dem von jeder Quelle ausgegebenen elektrischen Strom ein gemeinsames neutrales Verbindungsstück der Quellen hochfließt, wenn die detektierten resultierenden Magnetfelder eine gleiche Orientierung aufweisen; und
- die Gleichstromkomponente in dem von jeder Quelle ausgegebenen elektrischen Strom aus mindestens einer Quelle entspringt, wenn die detektierten resultierenden Magnetfelder nicht die gleiche Orientierung aufweisen und eine Summe gleich null oder unterhalb eines vorher festgelegten Werts aufweisen.

11. Messverfahren zum Messen einer Gleichstromkomponente von mindestens einem elektrischen Strom, wobei jeder elektrische Strom aus einer entsprechenden Quelle (4) ausgegeben wird, wobei das Messverfahren umfasst:
- Empfangen eines Detektionssignals von mindestens einem Stromdetektor (8), wobei jeder Stromdetektor (8) einer entsprechenden Quelle (4) zugehörig ist und beinhaltet:
- einen ersten Leiter (10), der sich zwischen einem ersten Anschluss (18) und einem zweiten Anschluss (20) erstreckt, wobei der erste Anschluss (18) und der zweite Anschluss (20) mit der Quelle (4) verbunden sind;
- eine röhrenförmige Abschirmung (12), hergestellt aus einem elektrisch leitfähigen Material und ein Innenvolumen (26) definierend, wobei die Abschirmung (12) konfiguriert ist, um einen geschlossenen elektrischen Pfad für Wirbelstromfluss bereitzustellen, um ein Kompensationsmagnetfeld zum Kompensieren einer zeitabhängigen Komponente eines Antwortmagnetfelds zu generieren, das durch einen Fluss des entsprechenden elektrischen Stroms in dem ersten Leiter (10) generiert wird; und
- einen Magnetsensor (14), angeordnet in dem Innenvolumen (26) der Abschirmung (12), wobei der Magnetsensor (14) konfiguriert ist, um ein resultierendes Magnetfeld in dem Innenvolumen (26) zu detektieren und das Detektionssignal auszugeben, wobei das Detektionssignal für das detektierte resultierende Magnetfeld repräsentativ ist,
wobei der erste Leiter (10) außerhalb des Innenvolumens (26) der Abschirmung (12) angeordnet ist,
- Bestimmen, für jede Quelle (4), der Gleichstromkomponente des entsprechenden elektrischen Stroms auf Grundlage des von dem Magnetsensor (14) des zugehörigen Stromdetektors (8) ausgegebenen Detektionssignals.

12. Messverfahren nach Anspruch 11, wobei jeder von mindestens zwei Stromdetektoren mit einer entsprechenden Quelle verbunden ist, wobei das Messverfahren weiter umfasst;
- Vergleichen der von jedem Magnetsensor ausgegebenen Detektionssignale miteinander; und
- Bestimmen, dass:
- die Gleichstromkomponente in dem von jeder Quelle ausgegebenen elektrischen Strom ein gemeinsames neutrales Verbindungsstück der Quellen hochfließt, wenn die detektierten resultierenden Magnetfelder eine gleiche Orientierung aufweisen; und
- die Gleichstromkomponente in dem von jeder Quelle ausgegebenen elektrischen Strom aus mindestens einer Quelle entspringt, wenn die detektierten resultierenden Magnetfelder nicht die gleiche Orientierung aufweisen und eine Summe gleich null oder unterhalb eines vorher festgelegten Werts aufweisen.

## Revendications

1. Appareil de mesure (2) pour mesurer une composante continue d'au moins un courant électrique, chaque courant électrique étant délivré par une source (4) correspondante, l'appareil de mesure (2) comprenant un ordinateur (6) et au moins un détecteur de courant (8), chaque détecteur de courant (8) étant associé à une source (4) correspondante et incluant :
- un premier conducteur (10) s'étendant entre une première borne (18) et une seconde borne (20) à des fins de connexion à la source (4) ;
- un écran (12) en forme de tube fait d'un matériau électroconducteur et définissant un volume interne (26), l'écran (12) étant configuré pour fournir un trajet électrique fermé pour une circulation de courant de Foucault pour générer un champ magnétique de compensation pour compenser une composante dépendant du temps d'un champ magnétique de réponse généré par une circulation, dans le premier conducteur (10), du courant électrique correspondant ; et
- un capteur magnétique (14) agencé dans le volume interne (26) de l'écran (12), le capteur magnétique (14) étant configuré pour détecter un champ magnétique résultant dans le volume interne (26), et pour délivrer un signal de détection représentatif du champ magnétique résultant détecté,
le premier conducteur (10) étant agencé à l'extérieur du volume interne (26) de l'écran (12),
l'ordinateur (6) étant connecté au capteur magnétique (14) de chaque détecteur de courant (8) pour recevoir le signal de détection correspondant,
l'ordinateur (6) étant configuré en outre pour déterminer, pour chaque source (4), la composante continue du courant électrique correspondant sur la base du signal de détection délivré par le capteur magnétique (14) du détecteur de courant (8) associé.

2. Appareil de mesure selon la revendication 1, dans lequel l'ordinateur (6) est configuré en outre pour délivrer, sur la base de chaque composante continue déterminée, un signal de commande pour commander la source correspondante à des fins de réduction ou d'annulation de la composante continue correspondante.

3. Appareil de mesure selon la revendication 1 ou 2, dans lequel chaque détecteur de courant (8) comprend en outre un noyau magnétique (16) présentant une première section agencée dans le volume interne de l'écran.

4. Appareil de mesure selon la revendication 3, dans lequel la première section du noyau magnétique comprend un entrefer, le capteur magnétique étant agencé dans l'entrefer.

5. Appareil de mesure selon la revendication 3 ou 4, dans lequel, pour chaque détecteur de courant, le premier conducteur correspondant est une bobine enroulée autour d'une seconde section du noyau magnétique.

6. Appareil de mesure selon la revendication 5, dans lequel la première section et la seconde section sont identiques, le premier conducteur et l'écran étant concentriques.

7. Appareil de mesure selon l'une quelconque des revendications 3 à 6, dans lequel, pour chaque détecteur de courant, le noyau magnétique est en forme de cerceau, l'écran s'étendant le long d'une direction toroïdale du noyau magnétique, le premier conducteur s'étendant à travers une ouverture centrale du noyau magnétique en forme de cerceau, ou étant enroulé autour de l'écran.

8. Appareil de mesure selon la revendication 7, dans lequel, pour chaque détecteur de courant, l'écran comprend une première extrémité et une seconde extrémité, la première extrémité et la seconde extrémité étant adjacentes l'une à l'autre, et étant en contact électrique l'une avec l'autre.

9. Appareil de mesure selon l'une quelconque des revendications 1 à 8, dans lequel l'écran est une bobine court-circuitée.

10. Appareil de mesure selon l'une quelconque des revendications 1 à 8, comprenant au moins deux détecteurs de courant, l'ordinateur étant configuré pour comparer, les uns aux autres, les signaux de détection délivrés par chaque capteur magnétique, et pour déterminer que :
- la composante continue dans le courant électrique délivré par chaque source circule vers une connexion neutre commune des sources, si les champs magnétiques résultants détectés présentent une même orientation ; et
- la composante continue dans le courant électrique délivré par chaque source provient d'au moins une source, si les champs magnétiques résultants détectés ne présentent pas la même orientation, et présentent une somme égale à zéro ou inférieure à une valeur prédéterminée.

11. Procédé de mesure pour mesurer une composante continue d'au moins un courant électrique, chaque courant électrique étant délivré par une source (4) correspondante, le procédé de mesure comprenant les étapes consistant à :
- recevoir un signal de détection provenant d'au moins un détecteur de courant (8), chaque détecteur de courant (8) étant associé à une source (4) correspondante et incluant :
- un premier conducteur (10) s'étendant entre une première borne (18) et une seconde borne (20), la première borne (18) et la seconde borne (20) étant connectées à la source (4) ;
- un écran (12) en forme de tube fait d'un matériau électroconducteur et définissant un volume interne (26), l'écran (12) étant configuré pour fournir un trajet électrique fermé pour une circulation de courant de Foucault pour générer un champ magnétique de compensation pour compenser une composante dépendant du temps d'un champ magnétique de réponse généré par une circulation, dans le premier conducteur (10), du courant électrique correspondant ; et
- un capteur magnétique (14) agencé dans le volume interne (26) de l'écran (12), le capteur magnétique (14) étant configuré pour détecter un champ magnétique résultant dans le volume interne (26), et pour délivrer le signal de détection, le signal de détection étant représentatif du champ magnétique résultant détecté,
le premier conducteur (10) étant agencé à l'extérieur du volume interne (26) de l'écran (12),
- déterminer, pour chaque source (4), la composante continue du courant électrique correspondant sur la base du signal de détection délivré par le capteur magnétique (14) du détecteur de courant (8) associé.

12. Procédé de mesure selon la revendication 11, dans lequel chacun parmi au moins deux détecteurs de courant est connecté à une source correspondante, le procédé de mesure comprenant en outre les étapes consistant à ;
- comparer, les uns aux autres, les signaux de détection délivrés par chaque capteur magnétique ; et
- déterminer que :
- la composante continue dans le courant électrique délivré par chaque source circule vers une connexion neutre commune des sources, si les champs magnétiques résultants détectés présentent une même orientation ; et
- la composante continue dans le courant électrique délivré par chaque source provient d'au moins une source, si les champs magnétiques résultants détectés ne présentent pas la même orientation, et présentent une somme égale à zéro ou inférieure à une valeur prédéterminée.
